Europäisches Patentamt

European Patent Office

Office européen des brevets

(19)

(11) EP 0 449 620 B1

(12) EUROPEAN PATENT SPECIFICATION

(45) Date of publication and mention
of the grant of the patent:
21.08.1996 Bulletin 1996/34

(51) Int Cl.$^6$: **H01L 29/772**, H01L 29/165,
H01L 29/161, H01L 21/265

(21) Application number: 91302712.4

(22) Date of filing: 27.03.1991

(54) **Semiconductor devices having a silicon/silicon-germanium heterostructure and methods of making the same**

Halbleiteranordnungen mit einer Silizium/Silizium-Germanium-Heterostruktur und Verfahren zu deren Herstellung

Dispositifs semi-conducteurs comportant une hétérostructure silicium/silicium-germanium et procédés de fabrication

(84) Designated Contracting States:
DE GB

(30) Priority: 29.03.1990 JP 78905/90

(43) Date of publication of application:
02.10.1991 Bulletin 1991/40

(73) Proprietor: KABUSHIKI KAISHA TOSHIBA
Kawasaki-shi, Kanagawa-ken 210 (JP)

(72) Inventor: Nakagawa, Akio,
c/o Intellectual Property Division
Minato-ku, Tokyo 105 (JP)

(74) Representative: Freed, Arthur Woolf et al
MARKS & CLERK,
57-60 Lincoln's Inn Fields
London WC2A 3LS (GB)

(56) References cited:
EP-A- 0 307 850          EP-A- 0 397 987
DE-A- 3 811 821

• IEEE ELECTRON DEVICE LETTERS, vol. 11, no. 1, January 1990, pages 45-47, IEEE, New York, US; KWOK K.NG. et al.: "Suppression of hot-carrier degradation in Si MOSFET's by germanium doping"
• IEEE ELECTRON DEVICE LETTERS, vol. EDL-7, no. 5, May 1986, pages 308-310, IEEE, New York, US; T.P. PEARSALL et al: "Enhancement- and depletion-mode p-channel GexSi1-x modulation-doped FET's"

## Description

The present invention relates generally to semiconductor devices and, more particularly, to a high-speed transistor device with a hetero-junction structure.

Conventionally, a high-electron mobility transistor, called the "HEMT" has been well known among those skilled in the art as one of semiconductor field effect transistors capable of executing high-speed switching operations by utilizing the hetero-junction structure. Such type of transistor may be defined as the field effect transistor which is comprised of gallium arsenide and gallium aluminum arsenide, with a Schottky metal contact on the gallium aluminum arsenide layer and two ohmic contacts penetrating into the gallium arsenide layer, serving as the gate, source and drain respectively.

Thus, the construction and operation of a HEMT are different from those of regular FETs. For example, IEEE EDL-11, 7, Jan 1990, pp 45-47 discloses an Si MOSFET in which Ge is doped into the source-channel-drain region. IEEE EDL-7, 5, May 1986, pp 308-310 discloses a p-channel modulation-doped FET in which a GeSi layer is located in the substrate at a predetermined distance from the surface thereof.

With the HEMT, what is called the "two-dimensional electron gas" spreads inside a non-doped gallium arsenide layer functioning as the channel region therefor, to thereby attain high-speed transistor operations. More specifically, the electron mobility of the HEMT can be further improved by having the use of the gallium arsenide layer as a channel region in addition to the physical nature of the gallium arsenide materials being used in the HEMTs, i.e., high electron mobility which has been inherent thereto. As a result, extra-high-speed switching operations can be accomplished for the HEMT.

However, the gallium-arsenide high-electron mobility materials come with a serious technical problem: It is very difficult to make a gate insulation layer of high quality, which has been easily obtained in the metal oxide semiconductor field effect transistors (MOSFETs) using one of the most popular semiconductor materials, i.e., silicon. Due to such difficulty in manufacture of the gate insulation layer, it cannot be expected that the HEMTs are manufactured successfully using the presently available manufacturing technology so as to have the insulated-gate (insulated gate) type. For this reason, while being strongly demanded among those skilled in the art, any ultra-high-speed transistor device with the mutual conductance gm that is high enough to exhibit a required switching speed has not been developed until today.

It is therefore an object of the present invention to provide a new and improved semiconductor device with heterostructure which can execute its switching operations at high speed.

In accordance with the above object, the present invention provides an insulated-gate transistor comprising an n-type silicon substrate, first and second p-type semiconductor layers, which are spaced apart from each other in said substrate, and a conductive layer insulatively provided above a surface portion of said substrate which is positioned between said first and second semiconductor layers, and a germanium-doped silicon layer laterally extending under said surface portion of said substrate, being in contact with said first and second semiconductor layers, wherein said insulated-gate transistor further comprises a silicon layer which serves as a first channel region in the surface portion of said substrate, being in contact with said first and second semiconductor layers, and in that said germanium-doped silicon layer is located under said silicon layer, having a predetermined thickness of its own and serving as a second channel region when a negative bias is applied to said conductive layer.

The foregoing and other objects, features and advantages of the invention will become more apparent in the detailed description which will be presented below.

In the detailed description of preferred embodiments of the present invention presented below, reference is made to the accompanying drawings in which:

Figure 1 is a diagram schematically showing a cross-sectional view of the main part of an insulated-gate semiconductor transistor in accordance with one preferred embodiment of the present invention;
Figure 2 is a diagram schematically showing a cross-sectional view of the main part of an insulated-gate semiconductor transistor in accordance with another embodiment of the present invention;
Figure 3 is a diagram schematically showing a cross-sectional view of the main part of an insulated-gate semiconductor transistor in accordance with a modification of the transistor shown in Figure 2.

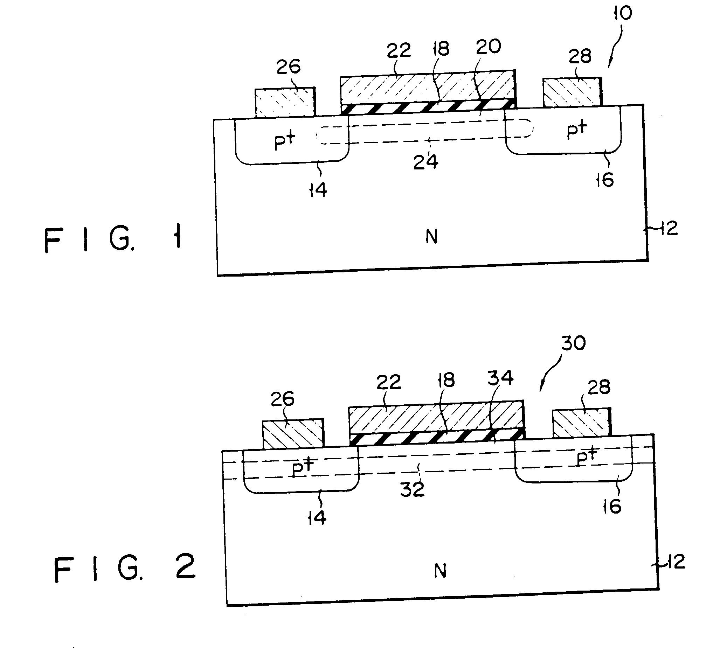

Referring now to Figure 1, a P-channel type metal oxide semiconductor filed effect transistor or MOSFET in accordance with one preferred embodiment of the present invention is generally designated by reference numeral "10." The MOSFET 10 has a silicon substrate 12 of N type conductivity. The N type substrate 12 has its top surface, in which a couple of heavily-doped P type (referred to as "P+ type" hereinafter) semiconductor layers 14 and 16 are formed by diffusion so that they are spaced apart from each other with a preselected distance being kept therebetween. The P+ type diffusion layer 14 serves as a source region for the MOSFET 10, whereas the P+ type diffusion layer 16 acts as a drain region therefor.

A thermal silicon oxide thin-film 18 is formed in a certain surface portion 20 which is positioned between the source layer 14 and the drain layer 16. On the layer 18 is formed a polycrystalline silicon layer 22 which is substantially self-aligned with the layers 14 and 16. The polycrystalline silicon layer 22 acts as the gate electrode of the MOSFET 10, while the underlying thermal oxide thin-film 18 functions as a gate insulation layer.

A specific kind of semiconductor doping species, such as germanium, is doped as an impurity into the surface portion of the silicon substrate 12 which is positioned beneath the gate insulation layer 18. A well-known ion-implantation method may be utilized to execute such doping of germaniun. A silicon germanium layer 24 is formed in the substrate surface portion. In this embodiment, the silicon germanium layer 24 is so defined as to be positioned in a preselected depth to have a predetermined thickness of its own, while allowing a shallow surface region of the substrate 12 to be maintained as a silicon layer, as shown in Figure 1. The silicon germanium layer 24 extends to enter into and partly overlap the source layer 14 and drain layer 16 at its both end portions, whereby the layer 24 is in contact with these layers 14 and 16. A patterned metallic layer 26 made of aluminum is arranged on the source layer 14. A patterned aluminum layer 28 is formed on the drain layer 16.

The MOSFET 10 shown in Figure 1 may be manufactured using a manufacturing method, which will be described below. First, a thermal oxide thin-film is formed in an element-formation area of the substrate 12. This thin-film serves as a buffer layer for ion implantation of impurity. Doping of germanium impurity is carried out so that the silicon germanium layer 24 is formed only in a selected region of the substrate 12. The layer 24 is located at a specific position of depth of the channel region of the MOSFET 10. In order to minimize the generation of mismatching or dislocation in the crystal lattice, it should be recommendable that the doping amount of germanium is limited to meet the following condition: The amount of germanium in the resultant silicon germanium layer 24 obtained by the ion implantation, i.e., the impurity concentration of germanium, is substantially equal to or less than thirty percent of the overall semiconductor amount of the substrate.

A gate insulation layer 18 is formed on the thermal oxide thin-film. A polycrystalline silicon layer is deposited on the gate insulation layer 18. The resultant double-layered structure is then subjected to a well-known photo-patterning process to obtain the gate electrode 22.

Subsequently, a preselected kind of semiconductor doping species of P type conductivity is selectively implanted into the substrate 12, with the gate electrode 22 being as a mask. The source layer 14 and the drain layer 16 are thus formed which are spaced apart from each other by a predetermined distance as shown in Figure 1. A chemical vapor deposition is carried out so that a $SiO_2$ layer is deposited to cover the entire top surface of the substrate 12. The insulative layer is patterned to define contact holes therein. Aluminum layers 26 and 28 are formed in these contact holes as the aforementioned source and drain electrodes of the MOSFET 10.

In the MOSFET 10 shown Figure 1, when a certain voltage of negative polarity is applied to the gate electrode 22, a channel region is defined in a specific surface region of the substrate 12 which is positioned just beneath the gate insulation layer 18. Holes appear also in an interface region between the silicon layer section 20 and the silicon germanium layer 24 that is narrower in its band gap than the silicon layer section 20. The interface region between the silicon germanium layer 24 and the silicon layer section 20 may acts as a second channel region for the MOSFET 10. A potential barrier is created due to the existence of the silicon layer section 20 of wide band gap which is positioned on the silicon germanium layer 24. The holes moving inside this second channel region are prevented by the potential barrier from coming into collision with the gate insulation layer 18. This enables the holes to run successfully through the channel region. The switching operation speed of the MOSFET 10 can thus be improved. In addition, the mutual conductance gm can be enhanced due to the fact that the gate insulation layer 18 is made of thermal silicon oxide thin-film.

Furthermore, according to this embodiment, the silicon germanium layer 24 is specifically arranged as shown in Figure 1 such that it laterally extends across the substrate surface portion defined between the source layer 14 and the drain layers 16. This means that any potential barrier, which blocks the passage of charge carriers moving-from the source layer 14 to the channel, will no longer be generated, which can improve the efficiency of carrier injection between the source layer 14 and the channel. Such improved efficiency of carrier injection will contribute to enhancement in the basic operation characteristics of the MOSFET 10.

It should be noted in the above embodiment that the silicon germanium layer 24 is required to be positioned accurately within an effective range of electric field being created in the substrate due to external application of a voltage to the gate electrode 22. The effective range of the internal electric field may be determined depending upon the physical dielectric breakdown characteristic of the gate insulation layer 18. In the case of using the maximum level of electric field Emax within the allowable range for the gate insulation layer 18, the maximum electric field Esub(max) which will be created inside the substrate 12 may be represented by the following equation:

$$Esub(max) = (\varepsilon_1/\varepsilon_2)Emax.$$

Where, "$\varepsilon_1$" is the dielectric constant of $SiO_2$ constituting the gate insulation layer 18, and "$\varepsilon_2$" is the dielectric constant of the silicon substrate 12. It is now apparent from the above equation that the charge amount, which makes it possible to form a depleted region in the substrate 12 by applying a voltage to the gate electrode 22, is $\varepsilon_2$. Esub(max), the value of which is approximately $1 \times 10^{13}$ cm$^{-2}$. This fact suggests that the impurity concentration of the substrate 12 and the formation depth of the silicon germanium layer 24 should be so arranged that the integrated value of impurity concentration in the specific surface region, which includes an interface of the gate insulation layer 18 and the silicon germanium layer 24, is not greater than $1 \times 10^{13}$ cm$^{-2}$. More preferably, the impurity concentration should be smaller than the value.

Turning now to Figure 2, a MOSFET in accordance with another embodiment of the present invention is generally designated by reference numeral "30." It is to be noted in this drawing that similar numerals are used to designate similar components to those of the earlier embodiment shown in Figure 1, and that detailed explanation therefor will be omitted in the following description, only for the purpose of simplification of description.

The MOSFET 30 is mainly featured in that a silicon germanium layer indicated by numeral "32" in Figure 2 and serving as a channel region is formed by using not the aforementioned ion implantation technique, but an epitaxial growth technique. More specifically, an epitaxial layer (32) of silicon germanium grows on the top surface of the substrate 12 so as to have its thickness of a preselected value. A silicon thin film 34 is formed by epitaxial crystal growth on the epitaxial layer 32 in the same manner as in the layer 34. The layer 34 corresponds to the layer section 20 shown in Figure 1. The resultant silicon germanium epitaxial layer 32 extends laterally through the entire ranges of the source layer 14 and the drain layer 18, as clearly illustrated in Figure 2. With such an arrangement, the aforementioned technical advantages can also be obtained.

The MOSFET 30 may be modified so that the silicon germanium layer 32 is replaced with a non-doped silicon layer. In such a case, the carrier mobility in the channel region can be further improved to attain more excellent transistor characteristics. Obviously, the conductivity type of the silicon thin film 34 should not be limited only to the N type as shown in Figure 2; it may be a P type. The important matter in this case is that, when the gate electrode 22 is being applied with a suitable voltage of the positive polarity, the layer section 34 positioned on the channel region of the substrate 12 (i.e., in the top surface portion of the substrate 12) is depleted successfully, and the interface region between the silicon germanium layer 32 and the silicon layer 34 is depleted simultaneously. It can be said that the above condition of channel formation is equivalent to the principle of what is called the "buried channel type MOSFET."

The germanium-ion implantation technique for forming the heterostructure inside the silicon substrate can be applied to bipolar transistor devices.

The present invention is not limited to the above-described embodiments, and may be practiced or embodied in still other ways without departing from the scope of the invention as defined by the appended claims.

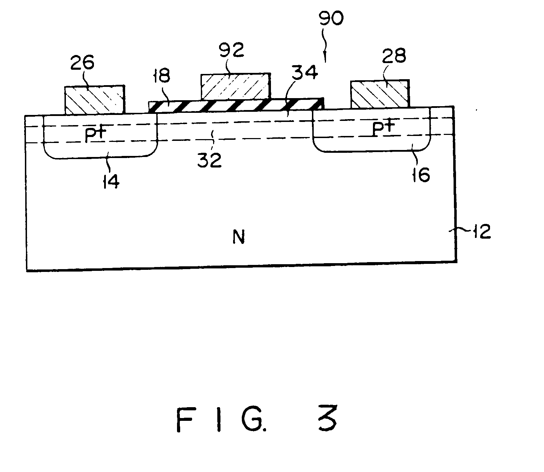

If required, either of the above-presented MOSFETs with the silicon/silicon-germanium heterostructure may be modified so as to have a gate electrode 92 of a decreased width as in a MOSFET 90 shown in Figure 3. With such an arrangement, it can be attained to decrease the stray or parasitic capacitance generated between the gate electrode 92 and the remaining components of the MOSFET 90, thereby to improve the basic characteristics thereof.

## Claims

1. An insulated-gate transistor (10, 30, 40, 50, 90) comprising an n-type silicon substrate (12, 52), first and second p-type semiconductor layers (14, 16; 54, 56), which are spaced apart from each other in said substrate, and a conductive layer (22, 92) insulatively provided above a surface portion of said substrate which is positioned between said first and second semiconductor layers (14, 16; 54, 56), and a germanium-doped silicon layer (24, 32, 42) laterally extending under said surface portion of said substrate, being in contact with said first and second semiconductor layers, said insulated-gate transistor (10, 30, 50, 90) further comprising a silicon layer (20, 34, 60) which serves as a first channel region in the surface portion of said substrate (12, 52), being in contact with said first and second semiconductor layers (14, 16; 54, 56), and said germanium-doped silicon layer (24, 32, 58) being located under said silicon layer (20, 34, 60), having a predetermined thickness of its own and serving as a second channel region when a negative bias is applied to said conductive layer (22, 92).

2. The transistor according to claim 1, characterized in that said conductive layer comprises a polycrystalline silicon layer (22, 92) which serves as a gate electrode of said transistor.

3. The transistor according to claim 2, characterized in that said silicon germanium layer comprises an impurity-doped layer (24) which is located in a preselected depth of said substrate (12) and laterally extended therein.

4. The transistor according to claim 2, characterized in that said silicon germanium layer comprises an epitaxial layer (32) which is provided in said substrate (12) in a pre-selected depth of said substrate and is laterally extended therein.

5. The transistor according to claim 3, characterized by further comprising an insulative thin-film (18) comprising a silicon oxide material, which is provided on said substrate (12) and electrically separates said gate electrode (22) from said substrate, and that said silicon germanium layer (24) is prevented from being in direct contact with said insulative thin-film (18).

6. The transistor according to claim 4, characterized by further comprising an insulative thin-film (18) comprising a silicon oxide material, which is provided on said substrate (12) for electrically separating said gate electrode (22) from said substrate, and that said silicon germanium layer (32) is prevented from being in direct contact with said insulative thin-film (18).

## Patentansprüche

1. Transistor (10, 30, 40, 50, 90) mit isoliertem Gate, mit einem n-Typ-Siliziumsubstrat (12, 52), ersten und zweiten p-Typ-Halbleiterschichten (14, 16; 54, 56), die voneinander in dem Substrat beabstandet sind, und einer leitenden Schicht (22, 92), die isolierend über einem Oberflächenteil des Substrates angeordnet ist, der zwischen den ersten und zweiten Halbleiterschichten (14, 16; 54, 56) gelegen ist, sowie einer mit Germanium dotierten Siliziumschicht (24, 32, 42), die sich seitlich unter dem Oberflächenteil des Substrates erstreckt, der in Berührung mit den ersten und zweiten Halbleiterschichten ist, wobei der Transistor (10, 30, 50, 9.0) mit isoliertem Gate weiterhin eine Siliziumschicht (20, 34, 60) aufweist, die als ein erster Kanalbereich in dem Oberflächenteil des Substrates (12, 52) dient, der in Berührung mit den ersten und zweiten Halbleiterschichten (14, 16; 54, 56) ist, und wobei die mit Germanium dotierte Siliziumschicht (24, 32, 58) unter der Siliziumschicht (20, 34, 60) gelegen ist, eine vorbestimmte Dicke aus sich selbst hat und als ein zweiter Kanalbereich dient, wenn eine negative Vorspannung an die leitende Schicht (22, 92) gelegt ist.

2. Transistor nach Anspruch 1, dadurch gekennzeichnet, daß die leitende Schicht eine polykristalline Siliziumschicht (22, 92) umfaßt, die als eine Gateelektrode des Transistors dient.

3. Transistor nach Anspruch 2, dadurch gekennzeichnet, daß die Silizium-Germanium-Schicht eine mit Fremd-stoff dotierte Schicht (24) aufweist, die in einer vorgewählten Tiefe des Substrates (12) gelegen ist und sich seitlich darin ausdehnt.

4. Transistor nach Anspruch 2, dadurch gekennzeichnet, daß die Silizium-Germanium-Schicht eine epitaxiale Schicht (32) aufweist, die in dem Substrat (12) in einer vorgewählten Tiefe des Substrates vorgesehen ist und sich seitlich darin ausdehnt.

5. Transistor nach Anspruch 3, gekennzeichnet durch weiterhin einen isolierenden Dünnfilm (18) mit einem Siliziumoxidmaterial, der auf dem Substrat (12) vorgesehen ist und elektrisch die Gateelektrode (22) von dem Substrat trennt, wobei die Silizium-Germanium-Schicht (24) daran gehindert ist, in direktem Kontakt mit dem isolierenden Dünnfilm (18) zu sein.

6. Transistor nach Anspruch 4, gekennzeichnet durch weiterhin einen isolierenden Dünnfilm (18) mit einem Siliziumoxidmaterial, der auf dem Substrat (12) vorgesehen ist, um elektrisch die Gateelektrode (22) von dem Substrat zu trennen, wobei die Silizium-Germanium-Schicht (32) daran gehindert ist, in direktem Kontakt mit dem isolierenden Dünnfilm (18) zu sein.

## Revendications

1. Transistor à isolation de grille (10, 30, 40, 50, 90) comprenant un substrat de silicium de type n (12, 52), des première et deuxième couches semiconductrices de type p (14, 16; 54, 56), espacées l'une de l'autre dans ledit substrat, et une couche conductrice (22, 92) agencée à isolement au-dessus d'une partie de surface dudit substrat, positionnée entre lesdites première et deuxième couches semiconductrices (14, 16; 54, 56), et une couche de silicium dopée au germanium (24, 32, 42) s'étendant latéralement au-dessous de ladite partie de surface dudit substrat, en contact avec lesdites première et deuxième couches semiconductrices, ledit transistor à isolation de grille (10, 30, 50, 90) comprenant en outre une couche de silicium (20, 34, 60) servant de première région de canal dans la partie de surface dudit substrat (12, 52), en contact avec lesdites première et deuxième couches semiconductrices (14, 16; 54, 56), et ladite couche de silicium dopée au germanium (24, 32, 58), agencée au-dessous de ladite couche de silicium (20, 34, 60), ayant une épaisseur prédéterminée propre et servant de deuxième région de canal en cas d'application d'une tension de polarisation négative sur ladite couche conductrice (22, 92).

2. Transistor selon la revendication 1, caractérisé en ce que ladite couche conductrice comprend une couche de silicium polycristallin (22, 92), servant d'électrode de grille dudit transistor.

3. Transistor selon la revendication 2, caractérisé en ce que ladite couche de silicium au germanium comprend une couche dopée d'impuretés (24) agencée à une profondeur présélectionnée dudit substrat (12) et s'étendant latéralement dans celui-ci.

4. Transistor selon la revendication 2. caractérisé en ce que ladite couche de silicium au germanium comprend une couche épitaxiale (32) agencée dans ledit substrat (12) à une profondeur présélectionnée dudit substrat et s'étendant latéralement dans celui-ci.

5. Transistor selon la revendication 3, caractérisé en ce qu'il comprend en outre une mince couche d'isolation (18) comprenant un matériau d'oxyde de silicium, agencée sur ledit substrat (12) et séparant électriquement ladite électrode de grille (22) dudit substrat, et en ce que l'établissement d'un contact direct est empêché entre ladite couche de silicium au germanium (24) et ladite couche mince d'isolation (18).

6. Transistor selon la revendication 4, caractérisé en ce qu'il comprend en outre une mince couche d'isolation (18) comprenant un matériau d'oxyde de silicium, agencée sur ledit substrat (12), pour séparer électriquement ladite électrode de grille (22) dudit substrat, et en ce que l'établissement d'un contact direct est empêché entre ladite couche de silicium au germanium (32) et ladite mince couche d'isolation (18).

EP 0 449 620 B1

FIG. 1

FIG. 2

7

F I G. 3